# EUROPEAN PATENT APPLICATION

(11) **EP 2 736 083 A2**
(43) Date of publication of application: **28.05.2014**
(21) Application number: 13186332.6
(22) Date of filing: 27.09.2013
(51) Int. Cl.: H01L 31/0216, H01L 31/0224, H01L 31/0749

(54) **Solar cell and method of manufacturing the same**

(30) Priority: 22.11.2012 KR 20120133146
(71) Applicant: Samsung SDI Co., Ltd., Yongin-si, Gyeonggi-do (KR)
(72) Inventor: Lee, Dong-Ho, Gyeonggi-do (KR); Kim, Young-Jin, Chungcheongnam-do 331-300 (KR); Kang, Ku-Hyun, Gyeonggi-do (KR); Oh, Min-Seok, Chungcheongnam-do 331-300 (KR); Huh, Kwang-Soo, Gyeonggi-do (KR); Shin, Jae-Ho, Chungcheongnam-Do 336-840 (KR)
(74) Representative: Mounteney, Simon James

(57) **Abstract**

A solar cell having improved electric energy generation efficiency and a method of manufacturing the solar cell. The solar cell includes a substrate (110), a rear electrode layer (120) on the substrate and comprising a first rear electrode (121) and a second rear electrode (122) spaced from each other, a window electrode layer (150) on the rear electrode layer and comprising a first window electrode (151) electrically coupled to the second rear electrode at a contact region (151c) on the second rear electrode, a light-absorbing layer (130) between the rear electrode layer and the window electrode layer, and an insulating layer (160a) on a first portion of the second rear electrode, wherein the first portion is between an edge of the second rear electrode facing the first rear electrode and the contact region.

## Description

### BACKGROUND

### 1.Field

An aspect of the present invention relates to a solar cell, and more particularly, to a solar cell and a method of manufacturing the same.

### 2.Description of the Related Art

With the continuous increase in energy demands and fossil fuel costs, solar cells for converting solar energy into electrical energy are under development. In particular, much attention has been paid to a solar cell in a thin-film structure which includes a substrate, a rear electrode layer, a p-type light absorbing layer, a buffer layer, and an n-type window electrode layer.

Such a thin-film solar cell includes a dead zone which is not used for electrical energy generation. If a dimension of the dead zone is reduced in an attempt to increase the efficiency of the electrical energy generation, the efficiency of electrical energy generation may be degraded due to a leakage current.

### SUMMARY

Embodiments of the present invention set out to provide a solar cell having improved electrical energy generation efficiency.

Embodiments of the invention also set out to provide a method of manufacturing a solar cell having improved electrical energy generation efficiency.

According to an aspect of the present invention, there is provided a solar cell including a substrate; a rear electrode layer on the substrate and comprising a first rear electrode and a second rear electrode spaced from each other; a window electrode layer on the rear electrode layer and comprising a first window electrode electrically coupled to the second rear electrode at a contact region on the second rear electrode; a light-absorbing layer between the rear electrode layer and the window electrode layer; and an insulating layer on a first portion of the second rear electrode, wherein the first portion is between an edge of the second rear electrode facing the first rear electrode and the contact region. The insulating layer may cover an entire top surface of the first portion of the second rear electrode. The insulating layer may cover a portion of a top surface of the first portion of the second rear electrode.

The insulating layer may include at least one material selected from among polyimide (PI), Kevlar, novolak, polyethylene terephthalate (PET), ethylenevinylacetate (EVA), and polycarbonate (PC). The insulating layer may include at least one material selected from among a silicon oxide, a silicon nitride, and a silicon nitric oxide.

The light-absorbing layer may include a first light-absorbing portion between the first rear electrode and the first window electrode, and the first light-absorbing portion may include a light-absorbing filling portion between the first rear electrode and the second rear electrode.

The light-absorbing filling portion may directly contact a side of the first rear electrode, a side of the second rear electrode, and the substrate at a location between the first rear electrode and the second rear electrode. The light-absorbing filling portion may have a higher conductivity than a remainder of the first light-absorbing portion other than the light-absorbing filling portion. The light-absorbing filling portion may have a higher conductivity in a direction towards the substrate. The light-absorbing filling portion may be integral to the first light-absorbing portion.

The light-absorbing filling portion may form a shunt current path between the first rear electrode and the second rear electrode when a potential of the first rear electrode is lower than a potential of the second rear electrode.

According to another aspect of the present invention, there is provided a method of manufacturing a solar cell. A conductive layer having a first region, a second region, and a third region between the first region and the second region is formed on a substrate. A rear electrode layer including a first rear electrode and a second rear electrode which are spaced from each other is formed by removing the conductive layer of the first region. An insulating layer is formed on at least a portion of a top surface of the conductive layer of the third region. A light-absorbing layer is formed on the rear electrode layer. A window electrode layer is formed on the light-absorbing layer.

During the forming of the window electrode layer, a first window electrode, which is electrically coupled to the second rear electrode, may be formed on the second region.

In the forming of the rear electrode layer and the insulating layer, the rear electrode layer including the first rear electrode and the second rear electrode, which are spaced from each other, may be formed on the region by patterning the conductive layer. The insulating layer may be formed on at least a portion of a top surface of the third region defined on the second rear electrode, after the rear electrode layer is formed.

In the forming of the rear electrode layer and the insulating layer, the insulating layer may be on at least a portion of a top surface of the conductive layer of the third region. The rear electrode layer including the first rear electrode and the second rear electrode on which the insulating layer is formed may be formed by patterning the conductive layer after the insulating layer is formed.

The insulating layer may be formed inkjet printing or screen printing. The insulating layer may be formed by chemical vapor deposition (CVD) or sputtering using a shadow mask.

The forming of the light-absorbing layer may include forming a first light-absorbing portion between the first rear electrode and a first window electrode, the first light-absorbing portion including a light-absorbing filling portion, between the first rear electrode and the second rear electrode.

In the forming of the light-absorbing filling portion, alkali ions may be diffused from the substrate to the light-absorbing filling portion.

At least some of the above and other features of the invention are set out in the claims.

### BRIEF DESCRIPTION OF THE DRAWINGS

The above and other features and aspects of the present invention will become more apparent upon referring to the following description of embodiments thereof with reference to the attached drawings in which:

FIG. 1 is a plan view illustrating a solar cell according to an embodiment of the present invention;

FIG. 2 is a cross-sectional view illustrating a cross-section taken along the line II - II' of the solar cell illustrated in FIG. 1;

FIG. 3 is a cross-sectional view illustrating a solar cell according to another embodiment of the present invention;

FIGS. 4A and 5 through 8 are cross-sectional views illustrating a processing flow to describe a method of manufacturing the solar cell illustrated in FIG. 2, according to an embodiment of the present invention; and

FIG. 4B is a cross-sectional view illustrating a method of manufacturing the solar cell illustrated in FIG. 2, according to another embodiment of the present invention.

### DETAILED DESCRIPTION

Hereinafter, various embodiments of the present invention will be described in detail with reference to the accompanying drawings. The embodiments of the present invention are provided to more completely describe the present invention to those of ordinary skill in the art. The embodiments provided below may be modified into other forms, and the scope of the present invention is not limited to the following embodiments and should be understood as including any changes, equivalents, and substitutes included in the technical scope of the present invention.

To describe the attached drawings, like reference numerals will refer to like components. In the attached drawings, the dimensions of structures may be exaggerated or reduced to help with understanding of the present invention.

Terms used herein are used merely for description of specific embodiments, without any intention to limit the scope of the present invention. As used herein, the singular forms are intended to include the plural forms as well, unless the context clearly indicates otherwise. It will be further understood that the terms "comprises" and/or "has" when used in this specification, specify the presence of stated features but do not preclude the presence or addition of one or more other features. As used herein, the term "and/or" includes any and all combinations of one or more of the associated listed items. It will be understood that, the terms first, second, etc., are only used to distinguish one feature from another feature for describing various features, and those features are not limited by these terms. In the following description, when an element is referred to as being "on" another element, it can be "directly on" the other element or intervening elements may also be present.

Unless otherwise defined, all terms (including technical and scientific terms) used herein have the same meaning as commonly understood by one of ordinary skill in the art to which the embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the drawings, for example, according to the manufacturing technology and/or tolerances, modification of the illustrated shape may be expected. Thus, the embodiments of the present invention should not be interpreted to be limited by a particular shape that is illustrated in the drawings and should include the possibility of a change in the shape occurring, for example, during manufacturing.

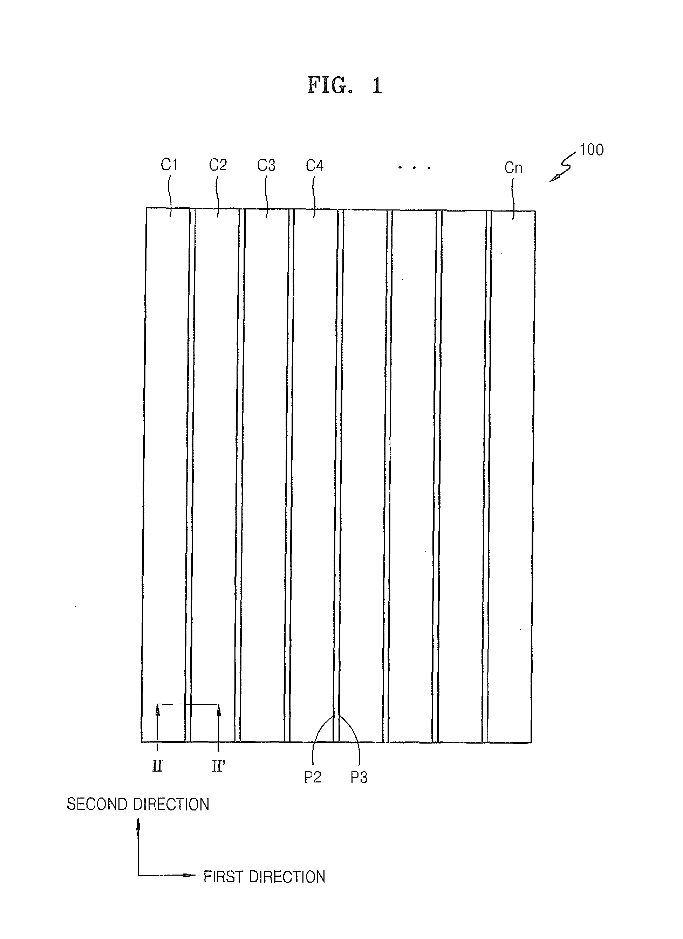

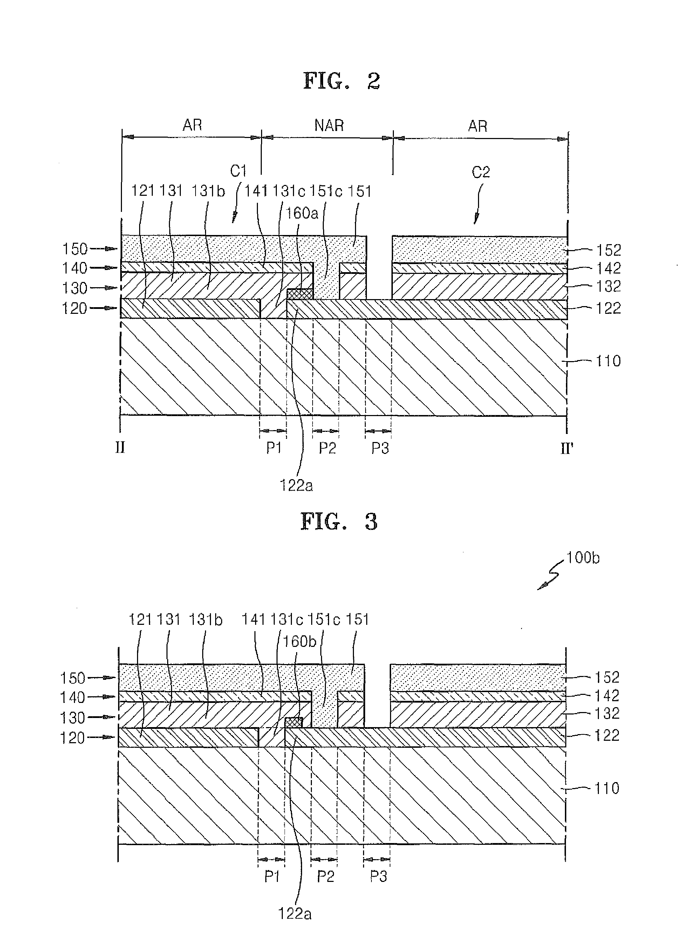

FIG. 1 is a plan view illustrating a solar cell according to an embodiment of the present invention, and FIG. 2 is a cross-sectional view illustrating a cross-section taken along the line II - II' of the solar cell illustrated in FIG. 1.

Referring to FIGS. 1 and 2, a solar cell 100 according to an embodiment of the present invention includes a plurality of unit solar cells C1 through Cn which extend in a second direction. The unit solar cells C1 through Cn are arranged along a first direction and may be serially connected with one another. According to a desired output voltage and output current of the solar cell 100, the unit solar cells C1 through Cn may be arranged in a different way than that shown in FIG. 1.

The solar cell 100 includes a substrate 110, a rear electrode layer 120 on the substrate 110, a light-absorbing layer 130 on the rear electrode layer 120, a buffer layer 140 on the light-absorbing layer 130, a window electrode layer 150 on the buffer layer 140, and an insulating layer 160a.

The rear electrode layer 120 includes a first rear electrode 121 and a second rear electrode 122. The light-absorbing layer 130 includes a first light-absorbing portion 131 and a second light-absorbing portion 132. The buffer layer 140 includes a first buffer portion 141 and a second buffer portion 142. The window electrode layer 150 includes a first window electrode 151 and a second window electrode 152. The first rear electrode 121, the first light-absorbing portion 131, the first buffer portion 141, and the first window electrode 151 form a first unit solar cell C1, including an active region AR of the first unit solar cell C1. The second rear electrode 122, the second light-absorbing portion 132, the second buffer portion 142, and the second window electrode 152 form the second unit solar cell C2, including an active region AR of the second unit solar cell C2. A non-active region NAR exists between the active region AR of the first unit solar cell C1 and the active region AR of the second unit solar cell C2. The non-active region NAR is an area in which electrical energy is not produced from solar light, and this region may also be referred to as a dead zone.

The dead zones may not contribute to electrical energy generation, such that as an area of the dead zone with respect to a total area increases, a total electrical energy generation efficiency may decrease. Therefore, to improve electrical energy generation efficiency, the area of the dead zone may be reduced. Referring to FIG. 1, the dead zones exist between the unit solar cells C1 through Cn, and thus it is difficult to reduce the area of the dead zones by reducing a length of the dead zones in the second direction, but a width of the dead zones in the first direction may be reduced. However, referring to FIG. 2, if a first gap P1 defined as being between the first rear electrode 121 and the second rear electrode 122 is reduced, a strong electric field may be generated in the first gap P1 and in the areas surrounding the first gap P1 due to a potential difference between the first rear electrode 121 and the second rear electrode 122. Consequently, holes of the light-absorbing layer 130 near the first gap P1 may not be directed towards the window electrode layer 150 due to the strong electric field and may be directed towards the second rear electrode 122 near the first gap P1, and thus recombining with electrons of the second rear electrode 122. Such recombination leads to a leakage current, thus degrading electrical energy generation efficiency.

According to embodiments of the present invention, to prevent the holes of the light-absorbing layer 130 near the first gap P1 from being recombined with electrons of the second rear electrode 122, the insulating layer 160a is disposed (or located) at a portion where recombination occurs. In this way, the insulating layer 160a prevents the holes of the light-absorbing layer 130 from being recombined with the electrons of the second rear electrode 122, thereby avoiding or reducing a leakage current due to the recombination.

A distance between the first rear electrode 121 and the second rear electrode 122 is shortest in the first gap P1, and thus the strongest electric field is generated in the first gap P1. On the other hand, the strength of the electric field from a top surface of the first rear electrode 121 towards a top surface of the second rear electrode 122 becomes reduced when going in a direction away from the first gap P1. However, the density of holes generated by light absorption in the light-absorbing layer 130 is higher at a top surface of the light-absorbing layer 130 than at a bottom surface of the light-absorbing layer 130. For example, the density of holes within the light-absorbing layer 130 may be about a hundred times higher than the density of holes within the first gap P1. Therefore, the recombination between the holes of the light-absorbing layer 130 and the electrons of the second rear electrode 122 more frequently (or dominantly) occurs along a path from the top surface of the first rear electrode 121 towards the top surface of the second rear electrode 122, rather than along a path through the first gap P1.

If the first gap P1 between the first rear electrode 121 and the second rear electrode 122, as well as the top surface of the second rear electrode 122, is filled with an insulating material, the first rear electrode 121 and the second rear electrode 122 may be completely insulated from each other. In this case, if light is irradiated to the first and second unit solar cells C1 and C2, the first rear electrode 121 has a higher potential than the second rear electrode 122, and a leakage current caused by the recombination may be avoided.

However, light may not be irradiated onto a particular unit solar cell even if light is irradiated to other unit solar cells. This case is referred to as partial shading. In this case, for example, if light is irradiated to the other unit solar cells C2 through Cn, except for the first unit solar cell C1, an inverse voltage may be generated in the first unit solar cell C1. In particular, when a max power point tracking technique is applied, an inverse voltage may be generated in a unit solar cell under partial shading conditions.

If the inverse voltage is generated, the potential of the first rear electrode 121 may be lowered to below the potential of the second rear electrode 122. For example, the potential of the first rear electrode 121 may be lower by about 1V or 2V than the potential of the second rear electrode 122. Such a potential difference results in a high voltage which is about 2 or 3 times an electrical energy generating voltage. If such a high voltage is applied between the first rear electrode 121 and the second rear electrode 122, shunting may occur in a weak portion in the first unit solar cell C1. The portion in which the shunting occurs may incur a permanent change due to Joule heating. Such a permanent change may be referred to as a hard breakdown.

Such a physical change remains even when partial shading no longer occurs in the unit solar cell, and acts as a permanent defect, reducing the total efficiency of the solar cell.

To prevent this phenomenon, according to embodiments of the present invention, the first gap P1 may be used as a shunt current path. The shunt current path allows the flow of a micro current between two terminals (i.e., the first and second rear electrodes) to prevent the voltage from being increased to over a certain voltage. With the shunt current path, the hard breakdown may be prevented. If there is no shunt current path between the first rear electrode 121 and the second rear electrode 122, the unit solar cell may, upon the occurrence of the partial shading, incur the hard break-down due to the inverse voltage.

As the solar cell 100 according to embodiments of the present invention has the shunt current paths, the magnitude of the inverse voltage applied to a unit solar cell may be limited in spite of the occurrence of partial shading. The unit solar cell in which the inverse voltage is generated operates as a resistor, thus reducing the level of consumed power.

Hereinafter, the cross-sectional structure of the solar cell 100 according to an embodiment of the present invention will be described.

The substrate 110 may be an insulating substrate having a plate shape. The substrate 110 may be a glass substrate, a polymer substrate, or a metal substrate which has superior light transmissivity. For example, soda-lime glass or high strain point soda glass may be used for the glass substrate, and polyimide may be used for the polymer substrate, but they are not limited to these examples. The glass substrate may be formed of low-iron tempered glass to protect internal elements from external shocks and improve a solar light transmissivity. In particular, in the case of low-iron soda-lime glass, sodium ions (Na+) of the glass are eluted at a processing temperature of 500°C or higher, thereby further improving the efficiency of the light-absorbing layer 130 formed of Copper-Indium-Galium-Selenide (Cu (In, Ga) Se2: CIGS). The substrate 110 may be transparent and rigid or flexible.

The rear electrode layer 120 may be formed of a metallic material having excellent conductivity and light reflexibility, such as molybdenum (Mo), aluminum (Al) or copper (Cu), to collect electric charges formed by a photoelectric effect and reflect light penetrating the light-absorbing layer 130 to allow the reflected light to be reabsorbed by the light-absorbing layer 130. In particular, the rear electrode layer 120 may be formed from molybdenum (Mo), based on high conductivity, ohmic contact with the light-absorbing layer 130, and high stability in a selenium (Se) atmosphere.

In one embodiment, the rear electrode layer 120 may have a thickness range from about 200 nm to about 500 nm, and may be divided into a plurality of rear electrodes by the first gap P1. The first gap P1 may be a groove which extends in the second direction of the substrate 110. In one embodiment, the first gap P1 may have a range from about 10 nm to about 70 µm in width. The rear electrode layer 120 includes the first rear electrode 121 and the second rear electrode 122 which are separated by the first gap P1. The first rear electrode 121 and the second rear electrode 122 have stripe shapes which extend in the second direction of the substrate 110.

Alkali ions such as sodium ions may be doped in the rear electrode layer 120. For example, in the growth of the CIGS light-absorbing layer 130, the alkali ions doped in the rear electrode layer 120 are mixed in the light-absorbing layer 130, thus exerting a structurally favorable influence upon the light-absorbing layer 130 and improving the conductivity of the light-absorbing layer 130, such that an open circuit voltage of the solar cell 100 may be increased.

The rear electrode layer 120 may be formed (e.g., implemented) as a multi-film to guarantee bonding with the substrate 110 and the resistance characteristics of the rear electrode layer 120.

The light-absorbing layer 130 may include a I group-III group-VI group compound. For example, the light-absorbing layer 130 may be formed of a Copper-Indium-Gallium-Selenide (Cu (In, Ga) Se2: CIGS)-based compound including copper (Cu), indium (In), gallium (Ga), and selenium (Se) to form a P-type semiconductor layer, and may absorb incident solar light. The light-absorbing layer 130 may have a Copper-Indium-Selenide-based or Copper-Gallium-Selenide-based crystalline structure. In one embodiment, the light-absorbing layer 130 may be formed to have a thickness range from about 0.7 µm to about 2 µm. In the embodiment, the energy band gap range of the light-absorbing layer 130 may be from about 1 eV to about 1.8 eV.

The light-absorbing layer 130 is divided into a plurality of light-absorbing portions by a third gap P3. The light-absorbing layer 130 includes the first light-absorbing portion 131 and the second light-absorbing portion 132 separated by the third gap P3. The first light-absorbing portion 131 is also separated by the second gap P2. The second gap P2 is a space in which a contact plug for an electrical connection between the first window electrode 151 and the second rear electrode 122 is formed.

The third gap P3 and the second gap P2 are grooves formed in parallel with the first gap P1 at positions different from that of the first gap P1. The second gap P2 is filled by the contact plug. In this sense, the second gap P2 may also be referred to as a contact region. The third gap P3 may expose the top surface of the second rear electrode 122.

The light-absorbing layer 130 also fills in the first gap P1 between the first rear electrode 121 and the second rear electrode 122. A filled-in portion of the first gap P1 may be referred to as a light-absorbing filling portion 131c. The portion of the first light-absorbing portion 131 other than the light-absorbing filling portion 131c may be referred to as a light-absorbing base portion 131b. That is, the first light-absorbing portion 131 may include the light-absorbing base portion 131b and the light-absorbing filling portion 131c.

As shown in FIG. 1, the light-absorbing filling portion 131c directly contacts a side of the first rear electrode 121, a side of the second rear electrode 122, and the first gap P1 of the substrate 110.

The light-absorbing filling portion 131c may have a higher conductivity than the light-absorbing base portion 131b to provide the shunt current path between the first rear electrode 121 and the second rear electrode 122. The light-absorbing filling portion 131c may be formed of the same material as and integrally with the light-absorbing base portion 131b. The light-absorbing filling portion 131c may directly contact the first gap P1 of the substrate 110 to absorb the alkali ions, for example, the sodium ions (Na+) diffused from the substrate 110. Due to an influence of the alkali ions, the light-absorbing filling portion 131c may have a higher conductivity than the light-absorbing base portion 131b. The light-absorbing filling portion 131c may also have a higher conductivity in a direction towards the substrate 110. For example, the light-absorbing filling portion 131c may have a conductivity higher than 10⁻⁴/Ωcm². Meanwhile, the light-absorbing base portion 131b may have a conductivity of about 10⁻⁴/Ωcm².

As a result, the light-absorbing filling portion 131c may function as the shunt current path if the inverse voltage is generated in the first unit solar cell C1 due to partial shading.

According to another example, the light-absorbing base portion 131b and the light-absorbing filling portion 131c may be formed of different materials. The light-absorbing filling portion 131c may be formed of a material having a higher conductivity than the light-absorbing base portion 131b to function as the shunt current path.

The insulating layer 160a is disposed on a top surface of a first portion 122a of the second rear electrode 122. The first portion 122a may be defined as a portion of the second rear electrode 122 positioned between the first gap P1 and the second gap P2. As illustrated in FIG. 2, the insulating layer 160a covers the entire top surface of the first portion 122a of the second rear electrode 122.

The insulating layer 160a may include at least one material selected from high-polymer materials having superior transmissivity, such as Kevlar, novolak, polyimide (PI), polyethylene terephthalate (PET), ethylenevinylacetate (EVA), and polycarbonate (PC). In this case, the insulating layer 160a may be formed by a screen printing method or an inkjet printing method.

According to another embodiment, the insulating layer 160a includes at least one inorganic insulating material selected from among a silicon oxide, a silicon nitride, and a silicon nitric oxide. In this case, the insulating layer 160a may be deposited using chemical vapor deposition (CVD) or sputtering. In the deposition process, a shadow mask having an opening corresponding to a portion in which the insulating layer 160a is to be formed may be used.

As described before, the insulating layer 160a may prevent the holes generated by irradiation of light on to the first light-absorbing portion 131 from being recombined with the electrons on the top surface of the second rear electrode 122. As a result, a leakage current may be reduced and electrical energy generation efficiency may be improved.

Moreover, since the recombination may be suppressed by the insulating layer 160a, the size of the first gap P1 may be reduced. That is, the area of the dead zone may be reduced, thereby improving electrical energy generation efficiency.

The window electrode layer 150 is formed on the light-absorbing layer 130 to form a P-N junction with the light-absorbing layer 130. The window electrode layer 150 may be formed of a transparent conductive material such as ZnOIB, ITO, or IZO, and may trap electrical charges formed by a photoelectric effect.

Although not shown, the top surface of the window electrode layer 150 may be textured to reduce reflection of incident solar light and increase light absorption by the light-absorbing layer 130.

The window electrode layer 150 is divided into a plurality of window electrodes by the third gap P3. The window electrode layer 150 includes the first window electrode 151 and the second window electrode 152. The third gap P3 may have a range from about 10 nm to about 70 µm in width. The third gap P3 may be the section that divides the first unit solar cell C1 and the second unit solar cell C2.

The first window electrode 151 fills in the second gap P2 to be directly and electrically connected with the second rear electrode 122. The portion filled in the second gap P2 may be referred to as a first window electrode contact 151c, and the first window electrode 151 includes the first window electrode contact 151c.

Although not shown, for the sake of processing, the insulating layer 160a is interposed between the first window electrode contact 151c and the second rear electrode 122.

Air or an organic or inorganic insulating material may be filled in the third gap P3 to insulate the plurality of unit solar cells C1, C2, ..., Cn from one another.

The buffer layer 140 is formed between the light-absorbing layer 130 and the window electrode layer 150 to reduce a band gap difference between the light-absorbing layer 130 and the window electrode layer 150 and to reduce recombination between electrons and holes in an interface between the light-absorbing layer 130 and the window electrode layer 150. The buffer layer 140 may be formed of cadmium sulfide (CdS), zinc sulfide (ZnS), indium sulfide (In₂S₃), or zinc magnesium oxide (ZnₓMg₍₁₋ₓ₎O). In one embodiment, the energy band gap range of the buffer layer 140 may be from about 2.2 eV to about 2.4 eV. The buffer layer 140 also includes the first buffer portion 141 and the second buffer portion 142 which are separated by the third gap P3.

Although not shown, a high-resistance buffer layer (not shown) is interposed between the buffer layer 140 and the window electrode layer 150. The high-resistance buffer layer may include zinc oxide (e.g., intrinsic zinc oxide (i-ZnO)) which is not doped with impurities. In one embodiment, the energy band gap range of the high-resistance buffer layer may be from about 3.1 eV to about 3.3 eV.

FIG. 3 is a cross-sectional view illustrating a solar cell 100b according to another embodiment of the present invention.

Referring to FIG. 3, except for the size of an insulating layer 160b, other components are substantially the same as those illustrated in FIG. 2 and thus will not be repetitively described here.

The solar cell 100b includes the insulating layer 160b which covers a portion of a top surface of the first portion 122a of the second rear electrode 122. The insulating layer 160b exposes the periphery of the second gap P2 of the second rear electrode 122 for the sake of processing.

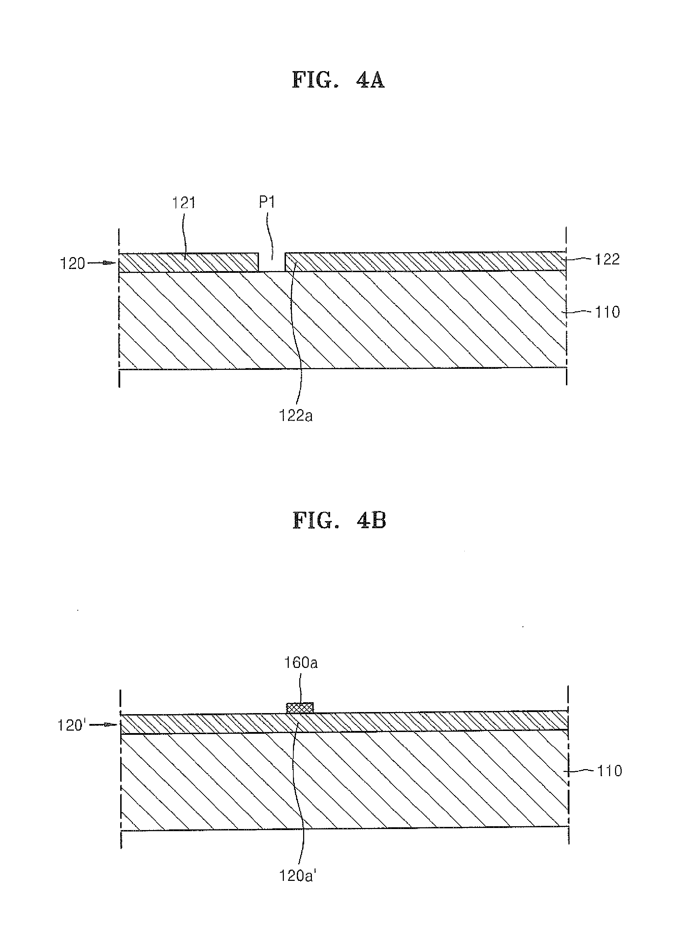

FIGS. 4A and 5 through 8 are cross-sectional views illustrating a processing flow to describe a method of manufacturing the solar cell 100 illustrated in FIG. 2 according to an embodiment of the present invention. In the current embodiment, the previous embodiment will be referred to. The foregoing description of the solar cell 100 may be incorporated into a description of the manufacturing method according to the current embodiment.

Referring to FIG. 4A, the rear electrode layer 120 is formed on the substrate 110. The rear electrode layer 120 may be formed by applying a conductive paste onto the substrate 110 and performing a thermal treatment or by performing processing such as plating. For example, the rear electrode layer 120 may be formed by sputtering using a molybdenum (Mo) target.

The rear electrode layer 120 is patterned to form the first gap P1. The patterning may be performed, for example, by laser scribing. Laser scribing is a process of irradiating a laser from under the substrate 110 towards the substrate 110 and evaporating a portion of the rear electrode layer 120 Through this process, the first gap P1, which divides the rear electrode layer 120 into a plurality of rear electrodes to be spaced apart from each other by a desired interval, may be formed.

Thus, the plurality of rear electrodes including the first rear electrode 121 and the second rear electrode 122 are formed on the substrate 110. The first gap P1 exposes the top surface of the substrate 110 and, in one embodiment, may have a width ranging from about 10 nm to about 70 nm.

An additional function layer such as a diffusion barrier may be interposed between the substrate 110 and the rear electrode layer 120. In this case, the first gap P1 exposes the top surface of the additional function layer.

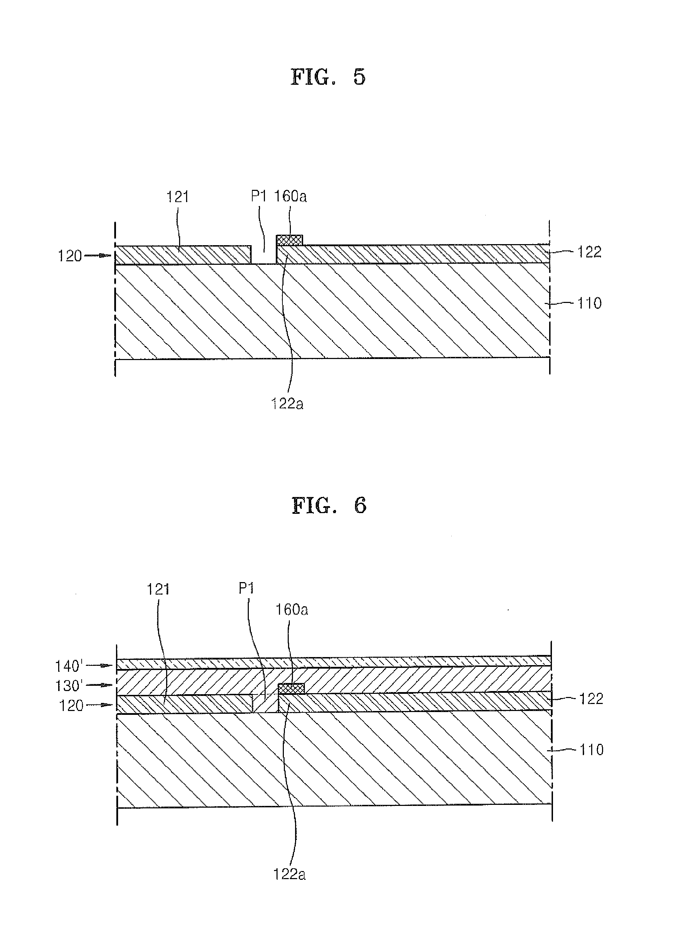

Referring to FIG. 5, the insulating layer 160a is formed on the first portion 122a of the second rear electrode 122. As described previously, the first portion 122a of the second rear electrode 122 may be defined as a portion of the second rear electrode 122 positioned between the first gap P1 and the second gap P2.

To form the insulating layer 160a, a thermal curing resin composition may be applied onto the first portion 122a of the second rear electrode 122. The thermal curing resin composition may include a monomer for forming a thermal curing resin. For example, the thermal curing resin composition may include a monomer such as bisphenol A, an imide-based monomer, terephthalic acid, ethyleneglycol, ethylene, and acetic acid vinyl to form EVA, PET, PC, or PI. The thermal curing resin composition may further include a thermal curing initiator.

The thermal curing resin composition may be applied by inkjet printing or screen printing.

A process may be additionally performed to remove the unnecessary portion of the thermal curing resin composition applied onto a region other than the first portion 122a of the second rear electrode 122.

The thermal curing resin composition applied onto the first portion 122a of the second rear electrode 122 may be thermally cured in an additional thermal treatment or subsequent high-temperature deposition such that the insulating layer 160a is formed.

The insulating layer 160a may include an inorganic insulating material such as a silicon oxide, a silicon nitride, or a silicon nitric oxide. In this case, the insulating layer 160a may be deposited by CVD or sputtering using a shadow mask.

The insulating layer 160b illustrated in FIG. 3 may also be formed in the same manner. However, the insulating layer 160b may be formed to have a narrower width than the insulating layer 160a, such that the insulating layer 160b may be formed on only a portion of the top surface of the first portion 122a of the second rear electrode 122.

FIG. 4B is a cross-sectional view for describing a method of manufacturing the solar cell 100 illustrated in FIG. 2 according to another embodiment of the present invention.

Referring to FIG. 4B, a conductive layer 120' is formed on the substrate 110. The conductive layer 120' is formed by applying a conductive paste onto the substrate 110 and performing a thermal treatment, or by performing plating. For example, the conductive layer 120' may be formed by sputtering using a molybdenum (Mo) target.

The insulating layer 160a is formed on a first portion 120a' of the conductive layer 120'. The first portion 120a' of the conductive layer 120' may be defined as a portion of the conductive layer 120' positioned between the first gap P1 and the second gap P2. A way to form the insulating layer 160a has already been described with reference to FIG. 5, and thus will not be repetitively described here.

Referring to FIG. 5, the conductive layer 120, on which the insulating layer 160a is formed, is patterned such that the first gap P1 is formed beside the insulating layer 160a. The patterning may be performed by laser scribing. Subsequent stages are the same as described in the manufacturing method according to an embodiment of the present invention, and thus the manufacturing method according to an embodiment of the present invention will be described.

Referring to FIG. 6, a light-absorbing layer 130' and a buffer layer 140' may be sequentially formed on the rear electrode layer 120.

The light-absorbing layer 130' may be formed by sputtering or evaporation. The light-absorbing layer 130' may be formed by co-evaporation, including putting copper (Cu), indium (In), gallium (Ga), and selenium (Se) into a small electric furnace installed in a vacuum chamber and heating the electric furnace for vacuum deposition. Alternatively, the light-absorbing layer 130' may be formed by sputtering/selenization, including forming a CIG-based metallic precursor film on the rear electrode layer 120 using a copper (Cu) target, an indium (In) target, or a gallium (Ga) target, and performing a thermal treatment in a hydrogen selenide (H₂Se) gas atmosphere to form the CIGS-based light-absorbing layer 130' through a reaction between the metallic precursor film and selenium (Se). The sputtering and selenization which use the copper (Cu) target, the indium (In) target, and the gallium (Ga) target may be performed at the same time. On the other hand, the CIS-based or CIG-based light-absorbing layer 130' may be formed using only the copper (Cu) target and the indium (In) target or by sputtering and selenization using the copper (Cu) target and the indium (In) target.

The light-absorbing layer 130' may also be formed by electrodeposition or molecular organic chemical vapor deposition (MOCVD).

The buffer layer 140' reduces a band gap difference between the light-absorbing layer 130' of a P type and the window electrode layer 150 of an N type and also reduces recombination between electrons and holes in an interface between the light-absorbing layer 130' and the window electrode layer 150. The buffer layer 140' may be formed by chemical bath deposition (CBD), atomic layer deposition (ALD), ion layer gas reaction (ILGAR), or the like. For example, the buffer layer 140' may be formed by depositing cadmium sulfide on the light-absorbing layer 130' through sputtering.

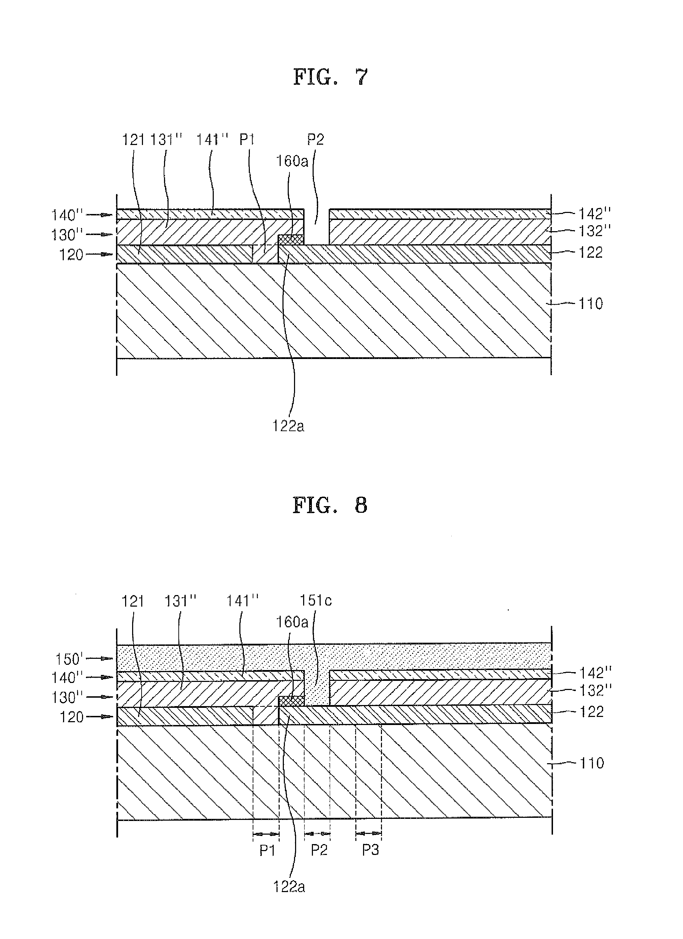

Referring to FIG. 7, by patterning the light-absorbing layer 130' and the buffer layer 140', the second gap P2 is formed to pass through a light-absorbing layer 130" and a buffer layer 140". A first light-absorbing portion 131" and a second light-absorbing portion 132" are separated by the second gap P2, and a first buffer portion 141" and a second buffer portion 142" are separated by the second gap P2. The second gap P2 is formed to expose a portion of the top surface of the second rear electrode 122.

The second gap P2 is formed adjacent to the first gap P1. The insulating layer 160a is positioned between the first gap P1 and the second gap P2. The second gap P2 may be formed by mechanical scribing, in which a sharp-tip tool such as a needle is used to form the second gap P2 (e.g., the needle is moved for formation of the gap). For example, the buffer layer 140' and the light-absorbing layer 130' may be patterned by a needle having a width ranging from about 50 µm to about 110 µm.

The second gap P2 may be formed by laser scribing. To this end, in one embodiment, a laser having a wavelength ranging from about 200 nm to about 600 nm may be used. In one embodiment, the width of the second gap P2 may range from about 100 µm to about 200 µm.

Referring to FIG. 8, the window electrode layer 150' may be formed on the buffer layer 140". The window electrode layer 150' may fill in the second gap P2. A portion of the window electrode layer 150' that fills in the second gap P2 may be referred to as the window electrode contact 151c. Thus, the window electrode contact 151c may be formed in the second gap P2 to extend from the window electrode layer 150' and to be directly connected to the second rear electrode 122.

To form the window electrode layer 150', a transparent conductive material such as ZnO:B, ITO or IZO may be deposited on the buffer layer 140". The window electrode layer 150' may be formed by MOCVD, low pressure chemical vapor deposition (LPCVD), or sputtering.

Referring back to FIG. 2, the window electrode layer 150', the buffer layer 140", and the light-absorbing layer 130" are patterned, such that the third gap P3 is formed to pass through the window electrode layer 150, the buffer layer 140, and the light-absorbing layer 130 and expose the second rear electrode 122. The first window electrode 151 and the second window electrode 152 are separated by the third gap P3.

Patterning for forming the third gap P3 may be performed by mechanical scribing or laser scribing. In one embodiment, the width of the third gap P3 may range from about 10 µm to about 100 µm.

Although not shown, the top surface of the window electrode layer 150 may be a textured surface. Texturing refers to forming an uneven pattern on the surface in a physical or chemical way. Once the surface of the window electrode layer 150 becomes uneven due to texturing, the reflexibility of incident light may be reduced, thus increasing a light trapping amount and thereby reducing optical loss.

The construction and method according to the described embodiments are not restrictively applied to the solar cell according to the present invention, and all of or some of the foregoing embodiments may be selectively combined to be modified in various ways.

In the solar cell and method of manufacturing the solar cell according to the present invention, the holes of the light-absorbing layer may be prevented from being recombined with the electrons of the rear electrode, thereby reducing a leakage current. Moreover, by adopting a structure capable of preventing recombination between the holes and the electrons, a distance between the rear electrodes may be reduced. That is, the area of a dead zone may be reduced. Therefore, the electrical energy generation efficiency with respect to a total area may be improved. In addition, an inverse voltage may be generated in the unit solar cell upon occurrence of partial shading. The solar cell according to embodiments of the present invention may have a shunt current path to prevent a sharp increase of the inverse voltage. As a result, a hard break-down, which is a permanent defect caused by the inverse voltage, may be suppressed, and unnecessary power consumption caused by the inverse voltage may be reduced by reducing the inverse voltage.

While embodiments of the invention have been particularly shown and described, it should be understood by those of ordinary skill in the art that various changes in form and details may be made therein without departing from the scope of the present invention as defined by the following claims and their equivalents. Thus, the embodiments described therein should be considered in a descriptive sense only and not for purposes of limitation.

## Claims

1. A solar cell comprising:
a substrate;
a rear electrode layer on the substrate and comprising a first rear electrode and a second rear electrode spaced from each other;
a window electrode layer on the rear electrode layer and comprising a first window electrode electrically coupled to the second rear electrode at a contact region on the second rear electrode;
a light-absorbing layer between the rear electrode layer and the window electrode layer; and
an insulating layer on a first portion of the second rear electrode, wherein the first portion is between an edge of the second rear electrode facing the first rear electrode and the contact region.

2. A solar cell according to claim 1, wherein the insulating layer covers an entire top surface of the first portion of the second rear electrode.

3. A solar cell according to claim 1, wherein the insulating layer covers a portion of a top surface of the first portion of the second rear electrode.

4. A solar cell according to any preceding claim, wherein the insulating layer comprises at least one material selected from among polyimide (PI), Kevlar, novolak, polyethylene terephthalate (PET), ethylenevinylacetate (EVA), and polycarbonate (PC).

5. A solar cell according to any preceding claim, wherein the insulating layer comprises at least one material selected from among a silicon oxide, a silicon nitride, and a silicon nitric oxide.

6. A solar cell according to any preceding claim, wherein the light-absorbing layer comprises a first light-absorbing portion between the first rear electrode and the first window electrode, and the first light-absorbing portion comprises a light-absorbing filling portion between the first rear electrode and the second rear electrode.

7. A solar cell according to claim 6, wherein the light-absorbing filling portion directly contacts a side of the first rear electrode, a side of the second rear electrode, and the substrate at a location between the first rear electrode and the second rear electrode.

8. A solar cell according to claim 6 or 7, wherein the light-absorbing filling portion has a higher conductivity than a remainder of the first light-absorbing portion other than the light-absorbing filling portion.

9. A solar cell according to claim 6, 7 or 8 wherein the light-absorbing filling portion has a higher conductivity in a direction towards the substrate.

10. A solar cell according to one of claims 6 to 9, wherein the light-absorbing filling portion is integral to the first light-absorbing portion.

11. A solar cell according to one of claims 6 to 10, wherein the light-absorbing filling portion is adapted to form a shunt current path between the first rear electrode and the second rear electrode when a potential of the first rear electrode is lower than a potential of the second rear electrode.

12. A method of manufacturing a solar cell, the method comprising:
forming, on a substrate, a conductive layer having a first region, a second region, and a third region between the first region and the second region;
forming a rear electrode layer comprising a first rear electrode and a second rear electrode which are spaced from each other by removing the conductive layer of the first region, and forming an insulating layer on at least a portion of a top surface of the conductive layer of the third region;
forming a light-absorbing layer on the rear electrode layer; and
forming a window electrode layer on the light-absorbing layer.

13. A method according to claim 12, wherein the forming of the rear electrode layer and the insulating layer comprises:
forming the rear electrode layer comprising the first rear electrode and the second rear electrode, which are spaced from each other on the first region, by patterning the conductive layer; and
forming the insulating layer on at least a portion of a top surface of the third region defined on the second rear electrode, after forming the rear electrode layer.

14. A method according to claim 12, wherein the forming of the rear electrode layer and the insulating layer comprises:
forming the insulating layer on at least a portion of a top surface of the conductive layer of the third region; and
forming the rear electrode layer comprising the first rear electrode and the second rear electrode on which the insulating layer is formed, by patterning the conductive layer after forming the insulating layer.

15. A method according to one of claims 12 to 14, wherein the forming of the light-absorbing layer comprises forming a first light-absorbing portion between the first rear electrode and a first window electrode, the first light-absorbing portion comprising a light-absorbing filling portion, between the first rear electrode and the second rear electrode.

16. A method according to claim 15, wherein the forming of the light-absorbing filling portion comprises diffusing alkali ions from the substrate to the light-absorbing filling portion.
